## Europäisches Patentamt

## European Patent Office

## Office européen des brevets

(11) Veröffentlichungsnummer: **0 184 820**
**A2**

(12) **EUROPÄISCHE PATENTANMELDUNG**

(21) Anmeldenummer: 85115712.3

(22) Anmeldetag: 10.12.85

(51) Int. Cl.⁴: **H 05 K 13/00**, H 05 K 3/00

(30) Priorität: 11.12.84 DE 3445188
22.02.85 DE 3506279

(43) Veröffentlichungstag der Anmeldung: 18.06.86
Patentblatt 86/25

(84) Benannte Vertragsstaaten: **AT BE CH DE FR GB IT LI LU NL SE**

(71) Anmelder: **MANIA Elektronik Automatisation Entwicklung und Gerätebau GmbH, Hauptstrasse 86, D-6384 Schmitten 2 (DE)**

(72) Erfinder: **Mang, Paul, Weilbergstrasse 4, D-6384 Schmitten 3 (DE)**
Erfinder: **Drilier, Hubert, Dipl.-Phys., Altkönigstrasse 11, D-6384 Schmitten 3 (DE)**
Erfinder: **Tschoep, Ekkehard, Beckerstrasse 22, D-6100 Darmstadt (DE)**

(74) Vertreter: **Ruschke, Hans Edvard et al, Patentanwälte Dipl.-Ing. Olaf Ruschke Dipl.-Ing. Hans E. Ruschke Dipl.-Ing. Jürgen Rost Dipl.-Chem. Dr. U. Rotter Pienzenauerstrasse 2, D-8000 München 80 (DE)**

(54) Anordnung zur Ausrichtung von unbelichteten Leiterplattenrohlingen und Fotomasken zueinander, sowie Fotomasken zur Verwendung darin.

(57) Anordnung zur Ausrichtung von unbelichteten Leiterplattenrohlingen 10 und Fotomasken 1, 2 zueinander bei der Herstellung von ein- und mehrlagigen Leiterplatten, mit am Rand der Fotomasken bzw. der Leiterplatten angeordneten, einander zugeordneten Positionierungshilfen, die bei der Leiterplatte 10 die Form von Positionierungsbohrungen 12 haben, wobei am Leiterplattenrohling auf einer oder beiden Seiten eine Fotomaske aufliegt. Das Neuartige besteht darin, dass die Positionierungshilfen am Rand der Fotomaske(n) die Form von lichtundurchlässigen Markierungen 6, 8 aufweisen, die Bestandteil des Musters 3, 4 der Maske(n) 1,2 sind,

dass eine Lichtquelle im wesentlichen paralleles Licht auf den Verbund aus Leiterplattenrohling und Fotomaske(n) und auf die Positionierungsbohrungen und die entsprechenden Markierungen richtet,

und dass eine elektronische Zeilenkamera (14) im Strahlengang des hindurchtretenden oder reflektierten Restlichtes angeordnet ist, die mit einer Auswertschaltung zur Ermittlung der Lage des Schattens der Markierung(en) 6, 8 im Verhältnis zu den Positionierungslöchern 12 versehen ist. Die neuartigen zur Verwendung in dieser Anordnung bestimmten Fotomasken mit den Ausrichtmarkierungen als Bestandteil des lichtdurchlässigen Musters der Fotomaske sowie das Verfahren zur Herstellung der Masken sind wichtige Aspekte der Erfindung.

FREI

zur Auswertschaltung

Licht

-------------------------------------------------------

Anordnung zur Ausrichtung von unbelichteten
Leiterplattenrohlingen und Fotomasken zueinander, sowie Fotomasken zur Verwendung darin

-------------------------------------------------------

Die vorliegende Erfindung betrifft eine Anordnung zur
Ausrichtung von unbelichteten Leiterplattenrohlingen und
Fotomasken zueinander bei der Herstellung von ein- und
mehrlagigen Leiterplatten oder Verdrahtungsträgern. Bekanntlich werden zur Herstellung von Verdrahtungsträgern
wie gedruckten Schaltungen, Keramikleiterplatten oder
flexiblen Schaltungen Leiterbahnen auf dem Substrat bzw.
Träger dadurch erzeugt, daß eine als Vorlage dienende
Fotomaske auf eine fotoempfindliche Schicht gelegt wird,
die sich auf der beispielsweise mit einer Kupferschicht bedeckten Trägeroberfläche befindet, und daß das Muster der Fotomaske durch Belichtung etwa mit ultraviolettem Licht auf den Lack übertragen wird. Der Lack besteht beispielsweise aus organischen Polymeren, die sich entweder unter der Wirkung des Lichtes vernetzen und so weniger löslich werden, oder in denen unter der Wirkung des UV-Lichtes Bindungen aufbrechen, so daß an den belichteten Stellen die Löslichkeit erhöht wird. Durch ein geeignetes Lösungsmittel lassen sich z.B. die belichteten Bereiche des Lackes auflösen. Die verbleibenden Bereiche des Lackes schützen den Träger vor dem Angriff eines nachfolgenden Ätzprozesses, mit dem das Kupfer zwischen den gewünschten Leiterbahnen der Leiterplatte beseitigt wird.

Gewöhnlich werden bei der Herstellung einer Leiterplatte die Anschlußbohrungen vor dem Übertragen des Musters von der Fotomaske auf den Fotolack angefertigt. Aufgrund der generellen Tendenz, immer feinere Muster bei gleichzeitig wachsenden Gesamtabmessungen der Leiterplatte herzustellen, liegt es auf der Hand, daß das Ausrichten der Fotomaske im Verhältnis zu der vorgebohrten Leiterplatte zu Problemen führen kann. Eine genaue Registrierung der Fotovorlage auf dem Basismaterial ist unbedingt erforderlich. Vielfach wird visuell justiert, was jedoch bei großen Serien unzweckmäßig ist. In solchen Fällen gibt es die Möglichkeit, halbautomatische Registrierrahmen zu verwenden, die im Belichtungsgerät eingebaut sind. Der Registrierrahmen enthält dann einen

Registrierblock mit zwei quer einstellbaren Aufnahmestiften für die Fixierung der Leiterplatte, wobei der gesamte Registrierblock horizontal und vertikal einstellbar ist. Auch bei derartigen Anordnungen läßt sich jedoch eine erhebliche manuelle Tätigkeit bei dem Ausrichten bzw. Registrieren nicht vermeiden.

Wegen der ständig steigenden Anforderungen an die Geometriestabilität der Fotomasken ist man zunehmend dazu übergegangen, Fotomasken aus Glas zu verwenden. Bei der Ausrichtung eines derartigen Fotodruckwerkzeuges im Verhältnis zu der zu belichtenden Leiterplatte hat man bisher vielfach im Glas sitzende Fangstifte verwendet, die in Fangbohrungen in der Leiterplatte passen. Auch wenn es im Verlauf des Bohrens einer Leiterplatte keine Schwierigkeit darstellt, diese Fangbohrungen an der vorgesehenen Stelle mit ausreichender Genauigkeit zu plazieren, da diese Fangbohrungen als Teil des gesamten Bohrprogramms der Leiterplatte hergestellt werden können, bereitet es doch erhebliche Schwierigkeiten, die Fangstifte in der Fotomaske unterzubringen, wie dies auch geschieht, und zwar insbesondere dann, wenn die Fotomaske aus Glas besteht. Gewöhnlich weist die Glasmaske zwei feststehende Fangstifte auf, von denen der eine dicht passend in eine Fangbohrung in der Leiterplatte eingreift, während der andere Fangstift in eine Fangbohrung mit Spiel (Langloch) eingreift, um eventuell vorhandene Längenabweichungen auszugleichen. Abgesehen von möglichen Fehlern bei der Plazierung der Fangstifte in der Glasmaske
und von dem erheblichen Arbeitsaufwand zum Einbringen der
Fangstifte hat diese Praxis den Nachteil, daß Ausrichtfehler
"systemimmanent" sind, da das Langloch gerade zur Anpassung
an solche Fehler vorgesehen ist. Die erforderliche Registriergenauigkeit mag im Bereich des einen Fangstiftes in der
dichtpassenden Fangbohrung noch eingehalten sein, irgendwelche Verzerrungen oder Längenänderungen in der Leiterplatte
oder der Fotomaske aufgrund von Temperaturänderungen, Luftfeuchtigkeit oder sonstigen Einflüssen wirken sich jedoch am
anderen Ende der Leiterplatte mit dem Langloch voll aus. Dies
bedeutet also, daß irgendwelche, etwa im Verlaufe des Herstellungsprozesses auftretende Dimensionsänderungen nicht
ausgemittelt werden können, d.h. Dimensionsveränderungen bei
den verschiedenen Herstellungsprozessen bleiben unbeachtet
bzw. unbemerkt und unkorrigiert.

Eine weitere Möglichkeit zur Ausrichtung von Fotomasken
bestand darin, daß Schablonen verwendet wurden, mit denen zum
Beispiel die Glasmasken einmal ausgerichtet und dann fixiert
wurden. Auch hierbei ist ein nicht unerheblicher Arbeitsaufwand notwendig, so daß er insbesondere bei häufigem Wechsel
der Fotomaske unzumutbar wird.

All diese Schwierigkeiten können durch die vorliegende Erfindung vermieden werden. Insbesondere wird durch die Erfindung
eine Anordnung zur Ausrichtung oder Registrierung von unbelichteten Leiterplattenrohlingen und Fotomasken zueinander bei der Herstellung von ein- und mehrlagigen Leiterplatten vorgesehen, durch die ohne manuelle oder visuelle Tätigkeiten bzw. Kontrollen eine optimale Ausrichtung der Fotomaske(n) im Verhältnis zu der vorgebohrten Leiterplatte und auch eine gegenseitige Registrierung von zwei Fotomasken bei beidseitiger Belichtung eines Leiterplattenrohlings ermöglicht wird. Insbesondere soll also auch die Ausrichtung der beiden Fotomasken zueinander vereinfacht und verbessert werden, wenn verschiedene Muster auf beide Seiten der gegebenenfalls vorgebohrten Leiterplatte aufzubringen sind.

Der Kern der vorliegenden Erfindung ist darin zu sehen, daß die Positionierungshilfen am Rand der Fotomaske(n) die Form von lichtundurchlässigen Markierungen aufweisen, die Bestandteil des Musters der Maske sind, wobei eien Lichtquelle im wesentlichen paralleles Licht im wesentlichen senkrecht auf den Verbund aus Leiterplattenrohling und Fotomaske(n) und durch die als Blende wirkenden Positionierungsbohrungen über die Markierungen richtet, und wobei auf der von der Lichtquelle abgewandten Seite des Verbundes im Bereich jeder Positionierungsbohrung eine elektronische Kamera, vorzugsweise eine Flächen- oder Zeilenkamera im Strahlengang des hindurchtretenden Restlichtes angeordnet ist, die mit einer Auswertschaltung zur Ermittlung der Lage des Schattens der Markierung(en) im Verhältnis zu den Positionierungsbohrungen versehen ist. Da die lichtundurchlässigen Markierungen auf den Fotomasken im Zuge der Herstellung der Fotomaske bzw. des darauf befindlichen Layouts etwa von einem Fotoplotter erstellt werden, was mit der höchsten Genauigkeit durchgeführt werden kann, und da diese Meßmarkierungen ohne den Umweg von mechanischen Fangstiften auf optischem Wege zur Einmittung der Meßmarkierungen im Verhältnis zu den Positionierungsbohrungen der Leiterplatte führen, ergibt sich nicht nur eine wesentliche Arbeitsersparnis bei der Registrierung bzw. Ausrichtung, sondern auch eine beachtliche Erhöhung der erzielbaren Präzision. Denn durch Verwendung einer geeigneten elektronischen Kamera kann über eine geeignete Auswertschaltung direkt (z.B. digital) abgelesen werden, wie die Markierung im Verhältnis zur Positionierungsbohrung angeordnet ist. So ist es außerdem auch möglich festzustellen, ob zwei gleiche Meßmarkierungen zweier Fotomasken auf beiden Seiten einer Leiterplatte genau senkrecht übereinander angeordnet sind. Denn wenn der Schatten oder die Reflexion beider übereinander angeordneter Meßmarkierungen breiter ist als der Schatten oder die Reflexion einer einzelnen Markierung, ist es klar, daß bei parallel einfallendem Licht ein Versatz der beiden Fotomasken zueinander gegeben ist.

In einer bevorzugten Ausgestaltung der Erfindung können die Markierungen auf der Fotomaske die einfachste denkbare Form, nämlich die Gestalt von geraden Linien haben, die senkrecht zum Rand der Fotomaske bzw. des Leiterplattenrohlings laufen. Es ist aber durchaus denkbar und in manchen Anwendungsfällen auch vorteilhaft, wenn die Markierungen andere Formen haben, so beispielsweise keilförmig. Bei Verwendung von je einer Fotomaske auf beiden Seiten der Leiterplatte kann es vorteilhaft sein, wenn die Markierungen unterschiedlich sind, beispielsweise eine Strichmarkierung auf der einen Maske und eine kreisförmige Aussparung auf der anderen Fotomaske.

Weiterhin kann es vorteilhaft sein, die Positionierungsbohrungen und die zugeordneten Markierungen jeweils in der Mitte der Ränder der Fotomaske(n) bzw. der Leiterplatte anzuordnen.

Hierdurch wird beispielsweise bei einer rechteckigen Leiterplatte das Zentrum derselben optimal eingemittelt, d.h. daß eine aufgrund des Herstellungsprozesses erfolgende ungewollte Längenzunahme der gesamten Fotomaske maximal nur zur Hälfte zur Auswirkung kommt, nämlich jeweils nur zu 50 % an jedem Rand.

Wenn die elektronische Kamera als eindimensional "sehende"

Zeilenkamera ausgebildet und parallel zum Rand des Leiterplattenrohlings orientiert ist, kann die Kamera besonders platzsparend untergebracht werden.

Bei Ausbildung der Fotomaske als Glasmaske ergibt sich in bekannter Weise eine besondere Dimensionsstabilität für die Fotomaske. Allerdings ist die vorliegende Erfindung bei derartigen Fotomasken auch von besonderem Vorteil, weil das Einbringen von Fangstiften gerade bei Glasmasken besonders schwierig ist.

Es ist möglich, das über die Auswertschaltung anzuzeigende Meßergebnis der Kamera dazu zu verwenden, die Fotomaske(n) und/oder den Leiterplattenrohling in ihrer/seiner Ebene mit Hilfe von Stellmotoren verdrehbar bzw. in Richtung
der jeweiligen X-Y-Koordinaten verschieblich anzuordnen,
wobei diese Motoren von der Auswertschaltung gesteuert zur
Optimierung der Mittigkeit der Markierungen im Verhältnis zu
den Positionierungslöchern vorgesehen sind.

Die Fotomaske(n) und/oder der Leiterplattenrohling sind
zweckmäßigerweise in der optimierten Lage fixierbar. Dies
kann beispielsweise dadurch geschehen, daß vakuumbetätigte
oder pneumatisch wirkende Mittel an den Masken und/oder der
Leiterplatte angreifen.

Die Verwendung einer Fotomaske mit Markierungen, die Bestandteil des lichtundurchlässigen Musters der Fotomaske sind, in
der erfindungsgemäßen Anordnung wird als im Rahmen der Erfindung liegend angesehen.

Einige Ausführungsbeispiele dieser Erfindung werden nachfolgend unter Bezugnahme auf die beigefügten Zeichnungen
beschrieben, die die Beispiele jeweils in prinzipieller
Darstellung zeigen.

Fig. 1    zeigt einen Schnitt durch einen Randabschnitt des
          Verbundes aus einer Leiterplatte und zwei Fotomasken, deren Markierungen im Sichtbereich einer
          Zeilenkamera an der Positionierungsbohrung der
          Leiterplatte anliegen,

Fig. 2    zeigt in einer Draufsicht eine bevorzugte Anordnung der Positionierungsbohrungen und der
          Meßmarkierungen auf der Leiterplatte bzw. der Fotomaske im Verhältnis zum Sichtfenster der
Zeilenkamera,

Fig. 3    zeigt ein Diagramm, welches den Verlauf der
Helligkeit darstellt, wie sie von der Zeilenkamera in einem Anwendungsfall ermittelt
wird (vor der Optimierung);

Fig. 4 bis 8 zeigen einen besonders vorteilhaften neuartigen Aufbau einer Fotomaske zur Verwendung
in der erfindungsgemäßen Anordnung; und

Fig. 9 bis 11 zeigen weitere bevorzugte Ausgestaltungen
der erfindungsgemäßen Anordnung.


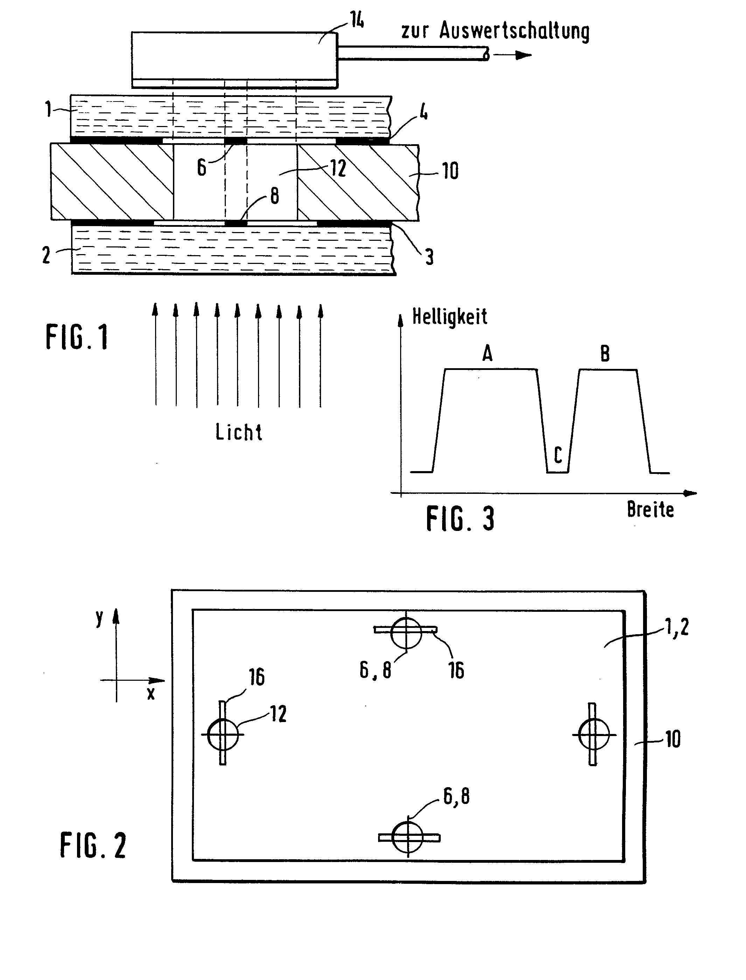

Auf beiden Seiten einer mit Fotolack beschichteten Leiterplatte 10 sind Fotomasken 1, 2, beispielsweise Glasmasken
angeordnet, die auf der der Leiterplatte zugewandten Fläche
mit einer lichtundurchlässigen Schicht 3 bzw. 4 versehen, die
ein Muster entsprechend dem gewünschten Muster auf der Leiterplatte ausbildet. Dieses Muster bildet also entsprechend
der bekannten Technik lichtdurchlässige und lichtundurchlässige Bereiche aus. Als Bestandteil dieses Musters sind erfindungsgemäß Markierungen 6, 8 in diesen Schichten 4, 3 ausgebildet, die im Bereich der Positionierungs- oder Blendenbohrung 12 der Leiterplatte angeordnet sind. Auf der von der
Leiterplatte 10 abgewandten Seite der oberen Fotomaske 1 ist
eine Zeilenkamera 14 so angeordnet, daß von der entgegengesetzten Seite dieses Verbundes aus Leiterplatte und Fotomasken einfallendes, im wesentlichen paralleles Licht durch
die Positionierungsbohrung 12 auf die Zeilenkamera 14 fällt.
Dabei bildet sich auf der eindimensional sehenden Zeilenkamera ein Schattenbild der Positionierungsbohrung 12 und der innerhalb derselben angeordneten Markierungen 6, 8 ab. In Fig. 1 sind die Schattengrenzen der Markierungen 6, 8 bzw. der Bohrung 12 strichliniert dargestellt. Dies führt dann auf der Zeilenkamera 14 beispielsweise zu einer Helligkeitsverteilung in Abhängigkeit von der Breite, wie sie in Fig. 3 dargestellt ist. In Fig. 1 betrachtet sieht die Zeilenkamera - von links kommend gesehen - zunächst Dunkelheit, um danach einen hellen Bereich zu erkennen, der in Fig. 3 mit A bezeichnet ist. Der sich anschließende Schatten der beiden Markierungen 6, 8 ist mit C bezeichnet, während rechts davon wieder ein belichteter Bereich B vorhanden ist, an den sich dann wieder Schatten anschließt, da die Positionierungs- oder Blendenbohrung 12 das übrige Licht zurückhält.

Wenn der Schattenbereich C der beiden Markierungen 6, 8 kleinstmöglich ist - vorausgesetzt beide haben die gleiche Größe - und wenn weiterhin die belichteten Bereiche A und B gleich groß sind, sind die beiden Fotomasken genau aufeinander ausgerichtet und zudem exakt in der Mitte der Positionierungsbohrung.

Wenn die Meßmarkierungen 6, 8 und die Postionierungsbohrungen 12 der Leiterplatte 10 in der Mitte der jeweiligen Ränder angeordnet sind, wie dies in Fig. 2 dargestellt ist, und wenn das Sichtfenster 16 der Zeilenkamera 14 im jeweiligen Meßbereich, also beispielsweise parallel zu den Rändern, die

Blendenbohrung überdeckend angeordnet ist, dann läßt sich die Leiterplatte im Verhältnis zu der Fotomaske über die Meßmarkierungen in Richtung der X-Koordinate in Richtung der Y-Koordinate einmitten und umgekehrt. Dies bedeutet, daß dann das Zentrum von Leiterplatte und Fotomasken in der bestmöglichen Weise zueinander eingemittet sind. Dadurch daß jeweils eine Kamera nur eine Richtung mißt, kann die Leiterplatte so ausgerichtet und belichtet werden, daß die theoretische Mitte optimal erhalten bleibt.

Die als solche bekannte Zeilenkamera (CCD-Zeile) besteht im Prinzip aus kleinen nebeneinander angeordneten lichtempfindlichen Abschnitten, z.B. Dioden, deren Mittenabstand im Berich von 13 $\mu$m liegen kann. Parallel dazu sind kleine Kondensatoren vorgesehen, wobei das Ganze als integrierte Schaltung ausgebildet ist. Beim Auftreffen von Licht werden die Dioden leitend, was dann zur Messung der Lage der Licht- bzw. Schattenbereiche verwendet werden kann. Das Auflösungsvermögen der Kamera entspricht dem Mittenabstand der einzelnen Dioden.

In einem konkreten Ausführungsbeispiel eines Belichtungsgerätes für ein- oder zweiseitig zu belichtende Leiterplatten sind zwei Rahmen zur Aufnahme der beiden Fotomasken mit den Meßmarkierungen, vorzugsweise Glasmasken, vorgesehen. Diese beiden Rahmen können entweder an einer Längsseite scharnierartig verbunden sein, so daß sie zum Einführen der zu belichtenden Leiterplatte auseinanderklappbar sind oder sie sind mittels geeigneter Geradführungen senkrecht gegeneinander bzw. auseinander bewegbar. Wenn es wie bei Multilayer-Leiterplatten auf die gegenseitige Registrierung der Fotomasken ankommt, werden diese mit Hilfe der von der Lichtquelle beleuchteten Markierungen gegeneinander ausgerichtet (Schatten C in Fig. 3), wonach die Fotomasken dann etwa pneumatisch oder mit Vakuum in diesem Rahmen fixiert werden. Wenn anschließend die zu belichtende Leiterplatte mit ihren Positionierungsbohrungen zwischen die dann schon aufeinander ausgerichteten Fotomasken eingebracht wird, braucht nur noch die Leiterplatte derart ausgerichtet zu werden, daß die Bereiche A und B in Fig. 3 im Bereich jeder Zeilenkamera einander (so gut wie möglich) gleichen. Dies kann mit von der Auswertschaltung in geeigneter Weise gesteuerten Stellmotoren selbsttätig geschehen. Wie in Fig. 2 angedeutet ist, arbeitet dieses konkrete Ausführungsbeispiel mit jeweils einer Zeilenkamera, einer Meßmarkierung und einer Positionierungsbohrung in der Randmitte der vier Ränder eines rechteckigen Arbeitsbereiches einer solchen Belichtungsmaschine.

Nachfolgend werden zunächst bekannte Herstellungsverfahren für Verdrahtungsträger erläutert. Anschließend wird eine besonders vorteilhafte Schichtfolge zur Herstellung einer Maske zur Erzeugung von Verdrahtungsträgern beschrieben, wobei diese Maske die oben angegebenen Markierungen aufweisen kann.

Bekannterweise werden zur Herstellung von Verdrahtungsträgern, wie gedruckten Schaltungen, Keramik-Leiterplatten
oder flexiblen Schaltungen, Leiterflächen bzw. Leiterbahnen
auf dem Substrat bzw. Träger dadurch erzeugt, daß eine als
Vorlage dienende Fotomaske auf eine fotoempfindliche
Schicht gepreßt wird, die sich auf der beispielsweise mit
eienr Kupferschicht bedeckten Trägeroberfläche befindet,
und daß das Muster der Fotomaske durch Belichtung mit
ultraviolettem Licht auf den Lack übertragen wird. Der Lack
besteht beispielsweise aus organischen Polymeren, die sich
entweder unter der Wirkung des Lichtes vernetzen und so
weniger löslich werden, oder in denen unter der Wirkung des
Lichtes Bindungen aufbrechen, so daß an den belichteten
Stellen die Löslichkeit erhöht wird. Durch ein geeignetes
Lösungsmittel lassen sich die belichteten Bereiche des
Lackes auflösen. Die verbleibenden Bereiche des Lackes
schützen den Träger vor dem Angriff eines nachfolgenden
Ätzprozesses, mit dem das Kupfer zwischen den gewünschten
Leiterbahnen der Leiterplatte beseitigt wird.

Aufgrund der generellen Tendenz, immer feinere Strukturen
bei gleichzeitig wachsenden Gesamtabmessungen herzustellen,
ist man dazu übergegangen, Fotomasken herzustellen, die
eine Glasschicht als Schichtenträger aufweisen. Der Vorteil
von Glas besteht darin, daß es eine außerordentlich große thermische Geometriestabilität besitzt. Ein Nachteil bei der Verwendung von Glas als Schichtenträger einer Photomaske besteht darin, daß sich auch bei Einhaltung von Reinraumbedingungen auf der Oberfläche der photoempfindlichen Schicht noch vorhandene Partikel bzw. Verunreinigungen auf der Glasoberfläche ansammeln und beim Belichten Fehler verursachen.

Daher wurde eine besonders vorteilhafte Schichtenfolge zur Herstellung einer Maske entwickelt, bei der Fehler, die beim Belichten auf Partikel bzw. Verunreinigungen zurückzuführen sind, weitgehend vermieden werden können.

Ein wesentlicher Vorteil dieser Schichtfolge besteht darin, daß mit ihr Verdrahtungsträger, wie beispielsweise gedruckte Schaltungen, Keramik-Leiterplatten und flexible Schaltungen unter Anwendung einer Foto-Ätztechnik fehlerfrei und genau herstellbar sind, weil infolge der vermiedenen elektrostatischen Aufladung der Oberfläche der Glasplatte dort vergleichsweise wenige Partikel bzw. Verunreinigungen anhaften, die Fehler verursachen könnten. Auf diese Weise kann die Fehlerquote sehr gering gehalten werden.

Ein weiterer wesentlicher Vorteil besteht darin, daß diese Schichtenfolge aus vorbeschichteten Glasplatten leicht herstellbar ist, so daß es dem Leiterplatten-Hersteller ermöglicht wird, durch Kontaktkopieren von einer beispielsweise gerade hergestellten Filmvorlage oder durch Direktbelichtung mittels eines Flachbett-Fotoplotters die jeweils
erforderlichen Fotomasken selbst herzustellen. Bisher
wurden dagegen Glasmasken außer Haus des Leiterplatten-
Produzenten hergestellt. Bei der Herstellung der vorliegenden Fotomasken beispielsweise durch den Leiterplatten-
Hersteller selbst, können sehr viel Zeit und Kosten eingespart werden. Außerdem können dabei Fehler vermieden werden, die bisher dadurch entstanden, daß beim Versenden
eienr Film-Vorlage zur Herstellung der Glasmaske an den
Hersteller die Geometrie der Film-Vorlage leicht verändert
wurde.

Zur Realisierung der erfindungsgemäßen Schichtfolge führten
die folgenden Überlegungen.

Bei den bekannten Fotomasken mit Glas als Schichtenträger
entstehen lokale elektrostatische Aufladungen der Glasoberfläche. Diese Aufladungen entstehen insbesondere durch den
Kontakt zwischen der fotoempfindlichen Schicht auf der
Leiterplatte und der einen hohen Oberflächenwiderstand
aufweisenden Glasschicht der Fotomaske der beispielsweise
durch ein Vakuum unterstützt wird, und durch das mechanische Trennen der beiden Oberflächen nach Abschluß des
Belichtungsvorganges. Die dabei entstehenden elektrostatischen Aufladungen der Glasoberfläche können nicht abfließen, weil das Glas einen sehr hohen Oberflächenwiderstand aufweist. Beim Aufbringen einer Glasmaske, deren Oberfläche elektrostatisch aufgeladen ist, auf der Oberfläche der fotoempfindlichen Schicht der zu belichtenden Leiterplatte sammeln sich auf der Oberfläche der fotoempfindlichen Schicht vorhandene Partikel bzw. Verunreinigungen an der Glasoberfläche an. Derartige Partikel bzw. Verunreinigungen sind auch bei Einhaltung von Reinraumbedingungen nicht vermeidbar. Bei den Belichtungsschritten verursachen die dann auf der Glasoberfläche vorhandenen Partikel bzw. Verunreinigungen Fehler. Erfindungsgemäß wird der Oberflächenwiderstand der Fotomaske durch eine leitfähige Schicht so niedrig gehalten, daß elektrostatische Aufladungen abfließen können und daher zuverlässig vermeidbar sind.

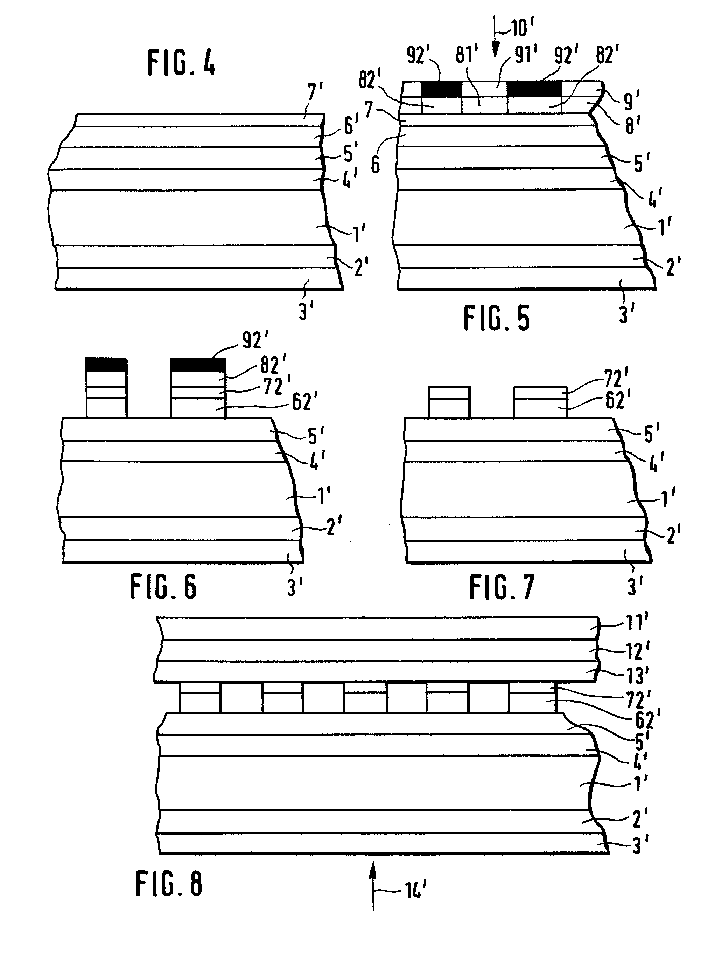

In der Figur 4 ist die Glasschicht der vorliegenden Maske mit 1' bezeichnet. Auf der einen Seite bzw. Oberfläche der Glasschicht 1' ist vorzugsweise eine Passivierungsschicht 4' angeordnet, wohingegen auf der anderen Seite bzw. Oberfläche der Glasschicht vorzugweise eine Passivierungsschicht 2' vorgesehen sein kann. Vorzugsweise bestehen die passivierungsschichten 2' und 4' aus $SiO_2$. Auf der der Glasschicht 1' abgewandten Seite der Passivierungsschicht 4' und gegebenenfalls auf der der Glasschicht 1' abgewandten Seite der Passivierungssshicht 2' ist jeweils eine leitfähige Schicht 5' bzw. 3' angeordnet. Die Schichten 2' und 3' werden vorgesehen, wenn auch die andere Seite der Glasschicht 1' antistatisch gehalten werden soll. Dabei sind diese leitfähigen Schichten 3', 5' für ultraviolettes Licht durchlässig und ätzmittelfest. Vorzugsweise bestehen die Schichten 3', 5' aus $SnO_2$, bei dem durch Dotierung die gewünschte Leitfähigkeit von etwa 1 $k\Omega/\square$ - 100 $k\Omega/\square$ erreicht wird.

Die Aufgabe der Passivierungsschichten 2' und 4' bestehen darin, einen Materialaustausch beim Aufbringen der weiteren Schichten bei hohen Temperaturen zu vermeiden. Dabei kann ein derartiger Materialaustausch zu Trübungen der Glasschicht 1' führen. Durch das Aufbringen der Passivierungsschichten können die entsprechenden Oberflächen der Glasschicht 1' vorteilhafterweise auch geglättet werden.

In Fällen, in denen der geschilderte Materialaustausch keine Rolle spielt, können die Passivierungsschichten entfallen.

Auf der der Glasschicht 1' abgewandten Seite der ätzmittelfesten, leitfähigen und für ultraviolettes Licht durchlässigen Schicht 5' ist eine für ultraviolettes Licht undurchlässige Schicht 6' vorgesehen, bei der es sich vorzugsweise um eine Nickel- oder Chromschicht handeln kann.

Auf der der Glasschicht 1' abgewandten Seite der
ätzmittelfesten, leitfähigen und für ultraviolettes Licht
durchlässigen Schicht 5' ist eine für ultraviolettes Licht
undurchlässige Schicht 6' vorgesehen, bei der es sich
vorzugsweise um eine Nickel- oder Chromschicht handeln
kann.

Auf der der Glasschicht 1' abgewandten Seite der Chromschicht 6' kann eine Absorbtuinsschicht 7' aufgebracht
werden, die beispielsweise aus Kupfer oder Kupferoxid
besteht. Die Aufgabe dieser Absorbtionsschicht 7' besteht
darin, die störenden Einflüsse einer hohen Reflexion an der
Chromschicht 6' zu vermindern.

Im folgenden wird nun im Zusammenhang mit Figur 5 erläutert, in welcher Weise aus der zuvor beschriebenen Schichtenfolge beispielsweise am Ort des Leiterplatten-Herstellers eine gewünschte Fotomaske hergestellt wird. Zunächst
wird auf der für das ultraviolette Licht undurchlässigen
Schicht 6', bei der es sich vorzugsweise um eine Chromschicht handelt, oder, falls vorhanden, auf der Absorbtionsschicht 7', die vorzugsweise aus Kupfer oder Kupferoxid besteht, eine Fotolackschicht 8' aufgebracht. Auf der
freien Oberfläche der Fotolackschicht 8' wird dann eine zur
Herstellung des gewünschten Leiterbahnmusters dienende
Maskierungsschicht 9 aufgebracht, die lichtdurchläsige
Bereiche 91 und lichtundurchlässige Bereiche 92 aufweist.

Wie dies aus der Figur 5 ersichtlich ist, wird anschließend in Richtung des Pfeiles 10 mit UV-Licht belichtet, wobei dieLöslichkeit der dem UV-Licht ausgesetzten Bereiche der Fotolackschicht 8' bei der Verwendung eines Positiv-Lackes erhöht wird. Bei einem nachfolgenden Entwicklungsschritt werden, wie dies aus der Figur 6 ersichtlich ist, die unterhalb der lichtdurchlässigen Bereiche 91' der Maskierungsschicht 9' befindlichen Bereiche 81' aus der Fotolackschicht 8' herausgelöst. Bei der Verwendung eines Negativ-Lackes kehren sich die Verhältnisse um, weil die belichteten Bereiche polymerisieren.

In einem nachfolgenden Ätzschritt, durch den die leitfähige Schicht 5' nicht angegriffen wird, werden die unterhalb der Bereiche 81' angeordneten Bereiche der Absorbtionschicht7' und die darunter befindlichen Bereiche 61' der Chromschicht 6' bzw. nur die Bereiche 61' der Chromschicht 6', wenn keine Absorbtionsschicht 7' verwendet wird, herausgelöst (Fig. 7). Die durch die Bereiche 92' geschützten Bereiche 72' und/oder 62' bleiben erhalten. Nach Entfernen der nicht polymerisierten Bereiche der Fotolackschicht 8' und der Restbereiche 92' der Markierungsschicht 9'ist die vorliegende Maske vollendet.

Diese Maske wird nun beispielsweise zur Herstellung einer Leiterplatte in der in der Figur 8 dargestellten Weise angewendet. Auf dem isolierenden Trägermateiral bzw. Substrat 11' eines Leiterplattenrohlings befindet sich eine metallische Schicht 12', bei der es sich beispielsweise um eine Kupferschicht handelt, aus der nachfolgend die Leiterbahnen hergestellt werden. Auf der Schicht 12' wird eine Fotolackschicht 13' aufgebracht. Schließlich wird auf die freie Seite der Fotolackschicht 13' die zuvor beschriebene Maske aufgesetzt, wobei die Bereiche 72' bzw. 62' der Schicht 13' zugewandt sind. Die so hergestellte Anordnung wird in der Richtung des Pfeiles 14' mit UV-Licht belichtet, wobei den Mustern/Bereiche 72' oder 62' der Maske entsprechend bestimmte Bereiche der Photolackschicht 13' polymerisieren. Durch nachfolgende, an sich bekannte Photo-Ätzschritte werden aus der unter der Fotolackschicht 13' befindlichen Kupferschicht 12 die gewünschten Leiterbahnen geätzt.

Wenn beide Seiten eines Leiterplattenrohlinges zur Herstellung von Leiterbahnen belichtet werden sollen, wird in der Figur 8 auch auf die der dargestellten Maske gegenüberliegende Seite der Leiterplatte ein eweitere vorliegende Maske aufgesetzt. Dabei befinden sich dann zwischen dieser weiteren maske und dem Substrat 11' der Leiterplatte eine weitere Kupferschicht und eine weitere Fotolackschicht (nicht dargestellt).

Die vorstehend beschriebene Maske kann so verwendet werden, daß sie die im Zusammenhang mit den Figuren 1 bis 3 beschriebenen Positionierungshilfen in der Form von lichtundurchlässigen Markierungen, die Bestandteil des Musters der Maske sind, aufweist. Durch eine derartige Ausgestaltung wird erreicht, daß die Maske besonders einfach in Bezug auf Leiterplattenrohlinge ausrichtbar ist.

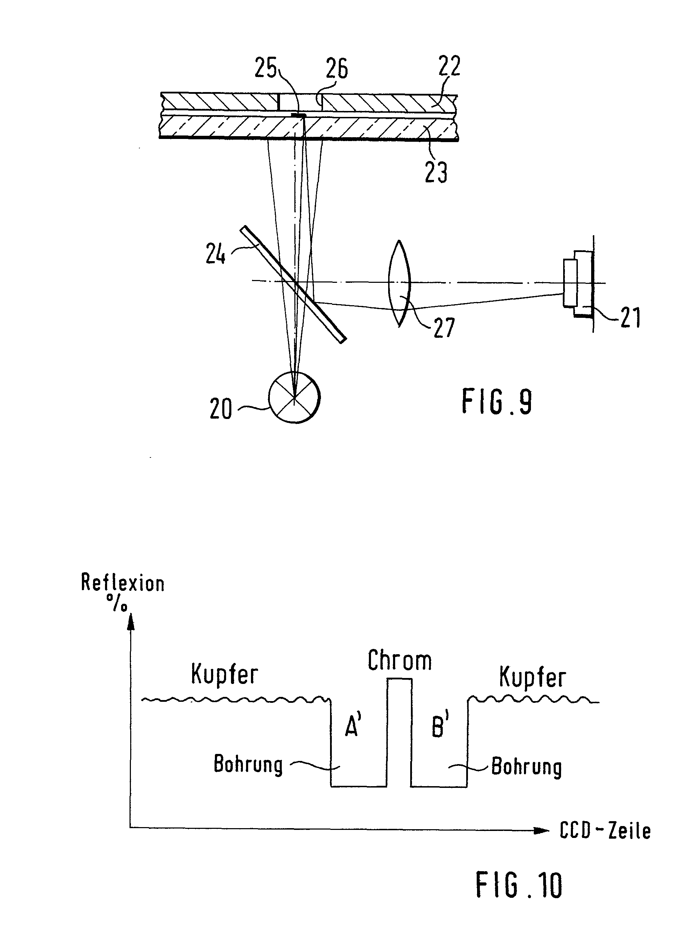

Aus den Figuren 9 und 10 geht eine Weiterbildung der Erfindung hervor, bei der sowohl die Lichtqulle 20 als auch die Zeilenkamera 21, bei der statt im Durchlichtverfahren im Reflexionsverfahren garbeitet wird, d.h., daß sowohl die Lichtquelle 20 als auch die Zeilenkamera 21, bei der es sich vorzugsweise um eine CCD-Zeile handelt, auf einer Seite der Leiterplatte 22 und der Fotomaske 23 angeordnet sind. Dabei wird das Licht der Lichtquelle 20 beispielsweise über einen Stahlteiler 24 auf die Meßmarkierung 25 der Fotomaske und die Positionerungsbohrung 26 der Leiterplatte 22 gerichtet. Das an der Markierung zurückreflektierte Licht wird über den Strahlteiler 24 und ein Abbildungssystem 27 der Zeilenkamera 21 zugeführt. Die Meßmarkierung 25 der Fotomaske und die Positionierungbsbohrung 26 der Leiterplatte 22 sind in der im Zusammenhang mit der Fig. 1 bis 3 beschriebenen Weise beschaffen. Dabei ergibt sich dann, wenn die Meßmarkierung 25 und die Positionierungsbohrung 26 mittig zueinander ausgerichtet sind, das in der Fig. 10 dargestellte Bild. Genauer gesagt ist in den Bereichen A' und B' die Reflexion sehr viel kleiner als die Reflexion an dem die Positionierungsbohrung 26 der Leiterplatte 22 z.B. umgebenden Kupfers und an der z.B. aus Chrom bestehenden Meßmarkierung 25. Bei der genauen Ausrichtung der Leiterplatte 22 zur Fotomaske 23 sind die Bereiche A' und B' gleich groß.

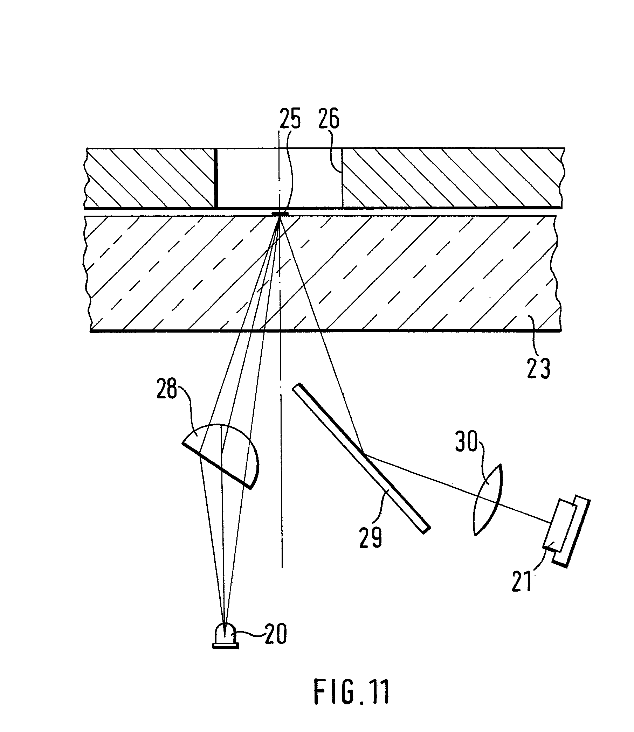

Aus der Fig. 11 geht eine weitere, der Fig. 9 ähnliche Ausgestaltung hervor, bei der sowohl die Lichtquelle 20 als auch die Zeilenkamera 21, die vorzugsweise wieder durch eine CCD-Zeile gebildet wird, auf einer Seite der Fotomaske 23 und der Leiterplatte 22 angeordnet sind. Die Meßmarkierung 25 der Fotomaske 23 und die Positionierungsbohrung 26 der Leiterplatte 22 sind in der bereits beschriebenen Weise ausgebildet. Das Licht der Lichtquelle 20 wird über eine Zylinderlinse 28 auf die Meßmarkierung 25 und die Positionierungsbohrung 26 gerichtet. Das dort am Rand der Positionierungsbohrung 26 und an der Meßmarkierung 26 reflektierte Licht wird der Zeilenkamera 21 über einen Spiegel 29 und einem Abbildungssystem 30 zugeführt. Auch bei dieser Anordnung ergibt sich bei der gewünschten Ausbildung die in Fig. 10 dargestellte Kurve.

Bei der Meßung oder Positionierung in Reflexionsverfahren nach der Weiterbildung der Erfindung gemäß den Figuren 9 bis 11 ist die lichtundurchlässige, das Muster der Fotomaske ausbildende Schicht vorzugsweise aus Chrom, d.h. eine Schicht mit hohem Reflexionsvermögen. Auch die Leiterplatte 22 selbst um die Positionierungsbohrung 26 herum hat ein gutes Reflexionsvermögen, da die leitfähige Schicht auf der Leiterplatte aus Kupfer gebildet ist. Bei der Messung im Reflexionsverfahren sieht die Kamera also die in Figur 10 gezeigte Helligkeitsverteilung, d.h. im Bereich der Positionierungsbohrung ist es neben der aus Chrom bestehenden Meßmarkierung 25 relativ dunkel (Bereiche A' und B' in Figur 10).

Wenn auf beiden Seiten der Leiterplatte 22 je eine Fotomaske angeordnet werden soll, so müssen diese - wie beim Durchlichtverfahren - zunächst aufeinander ausgerichtet werden. Dies kann beispielsweise dadurch geschehen, daß zunächst die in Figur 9 oder 11 gezeigte untere Fotomaske 23 mit einer Strichmarkierung 25 im Strahlengang der Meßanordnung fixiert wird. Anschließend wird dann die obere Fotomaske in die Meßanordnung eingebracht und im Verhältnis zu der unteren Fotomaske ausgerichtet. Zu diesem Zweck hat die obere Fotomaske eine Meßmarkierung in Form einer kreisförmigen Aussparung in der reflektierenden Chromschicht, wobei der Durchmesser dieser kreisförmigen Aussparung größer ist als die Positionierungsbohrung 26 der später einzubringenden Leiterplatte. Wenn zunächst nur die untere Fotomaske 23 mit der Strichmarkierung 25 und die obere Fotomaske mit der Aussparung im Strahlengang der Meßanordnung angeordnet werden, können diese beiden Fotomasken nach dem gleichen Prinzip zueinander ausgerichtet werden, wie dies bereits im Zusammenhang mit den Figuren 9 und 10 erläutert wurde, denn die kreisförmige Aussparung in der reflektierenden Chromschicht der oberen Fotomaske wirkt optisch auf die Meßanordnung wie die Positionierungsbohrung 26 in Verbindung mit der Strichmarkierung 25. Es ergibt sich also die gleiche Helligkeitsverteilung wie in Figur 10, wenn die beiden Fotomasken zueinander ausgerichtet sind. Im ausgerichteten Zustand werden die beiden Fotomasken dann durch geeignete Mittel, etwa pneumatisch oder mechanisch fixiert. Anschließend wird die Leiterplatte mit der Positionierungsbohrung 26 zwischen die beiden, bereits aufeinander ausgerichteten Fotomasken eingebracht und nach dem gleichen Verfahren auf die untere Leiterplatte mit der Strichmarkierung 25 ausgerichtet. Damit ist dann der ganze Verbund aus oberer und unterer Fotomaske und Leiterplatte korrekt angeordnet.

Bei der Messung im Reflexionsverfahren ist darauf zu achten, daß als reflektierende Oberfläche der Leiterplatte diejenige kupferkaschierte Oberfläche gewählt wird, in die der Bohrer beim Bohren der Positionierungsbohrungen eingetreten ist. Denn auf dieser Seite stellt sich ein besonders scharfer Bohrungsrad ein, der der Meßgenauigkeit zugute kommt. Gegenüber dem Durchlichtverfahren ergibt sich somit ein wesentlicher Vorteil, weil sich erfahrungsgemäß an der Innenwandung der Positionierungsbohrungen nicht unerhebliche Oberflächenrauhigkeiten ergeben, die bei der Durchlichtmessung in das Meßergebnis eingehen, nicht jedoch bei dem Reflexionsverfahren.

MÜNCHEN
Pienzenauerstraße 2
8000 München 80
Telefon: (0 89) 98 03 24,
98 72 58, 98 88 00
Telecopy Gr. II: (0 89) 222 066
Kabel: Quadratur München
Telex: 522 767 rush d

BERLIN
Kurfürstendamm 182/183
1000 Berlin 15
Telefon: (0 30) 8 83 70 78/79
Kabel: Quadratur Berlin

RUSCHKE & PARTNER
ANWALTSSOZIETÄT

**0 184 820**

Patentanwälte
Zugelassen beim Europäischen Patentan
Admitted to the European Patent Office

* in Berlin

Rainer Schulenberg
Rechtsanwalt
Zugelassen bei den LG München I und II
beim OLG München und dem
Bayer. Obersten Landesgericht

München, den 10. Dez. 1985

M 4519 HN

MANIA ELEKTRONIK AUTOMATISATION ENTWICKLUNG und

GERÄTEBAU GMBH,

Hauptstr. 86, 6384 Schmitten 2

---

Anordnung zur Ausrichtung von unbelichteten
Leiterplattenrohlingen und Fotomasken zueinander, sowie Fotomasken zur Verwendung darin

---

P a t e n t a n s p r ü c h e

1.     Anordnung zur Ausrichtung von unbelichteten Leiterplattenrohlingen und Fotomasken zueinander bei der Herstellung von ein- und mehrlagigen Leiterplatten, mit am
Rand der Fotomasken bzw. der Leiterplatten angeordneten,
einander zugeordneten Positionierungshilfen, die bei der
Leiterplatte die Form von Positionierungsbohrungen haben,
wobei am Leiterplattenrohling auf einer oder beiden Seiten
eine Fotomaske aufliegt,
dadurch gekennzeichent,
daß    die Positionierungshilfen am Rand der Fotomaske(n) die
       Form von lichtundurchlässigen Markierungen aufweisen,
       die Bestandteil des Musters der Maske sind,
daß    eine Lichtquelle im wesentlichen paralleles Licht
       auf den Verbund aus Leiterplattenrohling und Fotomaske(n) und auf die Positionierungsbohrungen und die entsprechenden Markierungen richtet,

und daß auf der von der Lichtquelle abgewandten Seite des Verbundes oder an derselben Seite wie die Lichtquelle jeder Positionierungsbohrung eine elektronische Kamera, vorzugsweise eine Flächen- oder Zeilenkamera im Strahlengang des hindurchtretenden oder reflektierten Restlichtes zugeordnet ist, die mit einer Auswertschaltung zur Ermittlung der Lage des Schattens der Markierung(en) im Verhältnis zu den Positionierungsbohrungen versehen ist.

2. Anordnung nach Anspruch 1, dadurch gekennzeichnet, daß die Markierungen auf der Fotomaske die Form von geraden Linien haben, die senkrecht zum Rand der Fotomaske bzw. des Leiterplattenrohlings verlaufen.

3. Anordnung nach Anspruch 1 oder 2, dadurch gekennzeichnet, daß die Positionierungslöcher und die zugeordneten Markierungen jeweils an der Mitte der Ränder der Fotomaske(n) angeordnet sind.

4. Anordnung nach einem der voranstehenden Ansprüche, dadurch gekennzeichnet, daß die (eindimensional "sehende") Zeilenkamera parallel zum Rand des Leiterplattenrohlings orientiert ist.

5. Anordnung nach einem der voranstehenden Ansprüche, dadurch gekennzeichnet, daß die Fotomaske eine Glasmaske ist.

6.   Anordnung nach einem der voranstehenden Ansprüche, dadurch gekennzeichnet, daß die Fotomaske(n) und/oder der Leiterplattenrohling in ihrer/seiner Ebene durch Stellmotoren verdrehbar und in Richtung der jeweiligen X-Y-Koordinaten verschieblich sind, wobei die Stellmotoren von der Auswertschaltung gesteuert zur Optimierung der Mittigkeit der Markierungen im Verhältnis zu den Positionierungslöchern versehen sind.

7.   Anordnung nach Anspruch 6, dadurch gekennzeichnet, daß die Fotomaske(n) und/oder der Leiterplattenrohling in der optimierten Lage fixierbar sind.

8.   Fotomaske zur Verwendung in einer Anordnung nach einem der voranstehenden Ansprüche, dadurch gekennzeichnet, daß sie die Markierungen aufweist, die Bestandteil des lichtundurchlässigen Musters sind.

9.   Fotomaske nach Anspruch 8, dadurch gekennzeichnet, daß auf einer Oberfläche einer Glasschicht (1) eine leitfähige, lichtdurchlässige und ätzmittelfeste Schicht (5) aufgebracht ist, und daß sich auf der der Glasschicht (1) abgewandten Seite der leitfähigen und lichtdurchlässigen Schicht (5) eine selektiv ätzbare lichtundurchlässige Schicht (6) befindet.

10. Fotomaske nach Anspruch 9, dadurch gekennzeichnet, daß auf der der einen Oberfläche gegenüberliegenden anderen Oberfläche der Glasschicht (1) eine weitere leitfähige, lichtdurchlässige und ätzmittelfeste Schicht (3) aufgebracht ist.

11. Fotomaske nach Anspruch 9 oder 10, dadurch gekennzeichnet, daß zwischen der leitfähigen, lichtdurchlässigen und ätzmittelfesten Schicht (5) und der Glasschicht (1) eine Passivierungsschicht (4) vorgesehen ist.

12. Fotomaske nach Anspruch 10 oder 11, dadurch gekennzeichnet, daß zwischen der leitfähigen, lichtdurchlässigen und ätzmittelfesten weiteren Schicht (3) und der Glasschicht (1) eine weitere Passivierungsschicht (2) vorgesehen ist.

13. Fotomaske nach Anspruch 11 oder 12, dadurch gekennzeichnet, daß als Passivierungsschicht (4) und gegebenenfalls als weitere Passivierungsschicht (2) $SiO_2$-Schichten vorgesehen sind.

14. Fotomaske nach einem der Ansprüche 9 bis 13, dadurch gekennzeichnet, daß als leitfähige, lichtdurchlässige und ätzmittelfeste Schicht (5) und gegebenenfalls als weitere leitfähige, lichtdurchlässige und ätzmittelfeste Schicht (3) schwach dotierte $SnO_2$-Schichten vorgesehen sind.

15. Fotomaske nach Anspruch 14, <u>dadurch gekennzeichnet,</u> daß die dotierten $SnO_2$-Schichten (3, 5) eine Leitfähigkeit von etwa 1 k$\Omega$/□ bis etwa 100 k$\Omega$/□ besitzen.

16. Fotomaske nach einem der Ansprüche 9 bis 15, <u>dadurch gekennzeichnet,</u> daß als lichtundurchlässige Schicht eine Nickel- oder Chromschicht (6) vorgesehen ist.

17. Fotomaske nach einem der Ansprüche 9 bis 16, <u>dadurch gekennzeichent,</u> daß auf der der Glasschicht (1) abgewandten Oberfläche der lichtundurchlässigen Schicht (6) eine nicht reflektierende und ätzbare Absorbtionsschicht (7) aufgebracht ist.

18. Fotomaske nach Anspruch 17, <u>dadurch gekennzeichnet,</u> daß als Absorbtionsschicht (7) eine Kupfer- oder Kupferoxidschicht vorgesehen ist.

19. Verwendung einer Fotomaske mit Ausricht-Markierungen (6, 8; 25), die Bestandteil des lichtundurchlässigen Musters der Fotomaske sind, in einer Anordnung nach einem der Patentansprüche 1 - 7.

20. Verfahren zur Herstellung einer Fotomaske zur Verwendung in einer Anordnung nach einem der Patentansprüche 1 - 7, <u>dadurch gekennzeichnet,</u> daß die Ausricht-Markierungen (6, 8; 25) als Bestandteil des lichtundurchlässigen Musters der Fotomaske hergestellt werden.

14

zur Auswertschaltung

1

4

6

12

10

8

3

2

**FIG.1**

Licht

Helligkeit

A

B

C

Breite

**FIG. 3**

y

x

1,2

6,8

16

16

12

6,8

10

**FIG. 2**

FIG. 4

FIG. 5

FIG. 6

FIG. 7

FIG. 8

25   26   22

23

24

20

27   21

FIG.9

Reflexion
%

Kupfer          Chrom          Kupfer

A'          B'

Bohrung          Bohrung

CCD-Zeile

FIG.10

FIG.11